# EUROPEAN PATENT SPECIFICATION

(11) **EP 2 953 174 B1**
(45) Date of publication and mention of the grant of the patent: **01.07.2020**
(21) Application number: 14745940.8
(22) Date of filing: 30.01.2014
(51) Int. Cl.: C09K 11/59, C09K 11/64, C09K 11/78, C09K 11/73

(54) **LIGHT EMITTING DEVICE AND LED LIGHT BULB**
LICHTEMITTIERENDE VORRICHTUNG UND LED-GLÜHLAMPE
DISPOSITIF ÉLECTROLUMINESCENT ET AMPOULE LUMINEUSE À DIODE ÉLECTROLUMINESCENTE (DEL)

(30) Priority: 31.01.2013 JP 2013017443; 31.01.2013 JP 2013017444
(43) Date of publication of application: 09.12.2015
(73) Proprietor: Kabushiki Kaisha Toshiba, Minato-ku Tokyo 105-8001 (JP); Toshiba Materials Co., Ltd., Yokohama-shi, Kanagawa 235-8522 (JP)
(72) Inventor: YAMAKAWA, Masahiko, Tokyo 105-8001 (JP); SHIRAKAWA, Yasuhiro, Tokyo 105-8001 (JP); KONDO, Hiroyasu, Tokyo 105-8001 (JP); TSUDA, Ryoji, Tokyo 105-8001 (JP); ITOGA, Tatsunori, Tokyo 105-8001 (JP); OKAMURA, Masami, Tokyo 105-8001 (JP)
(74) Representative: Hoffmann Eitle
(86) International application number: PCT/JP2014/000480
(87) International publication number: WO 2014/119313

(56) References cited:
- WO-A1-2007/114614
- JP-A- 2012 199 218
- US-A1- 2005 212 404
- US-A1- 2007 274 093
- US-A1- 2012 056 209
- US-A1- 2012 326 627
- US-B1- 7 288 902

## Description

### FIELD

The present invention relates to a light emitting device and an LED light bulb.

### BACKGROUND

Light emitting devices using light emitting diodes (LED) are widely used as lighting devices such as a backlight of a liquid crystal display device, a signal device, various kinds of switches, an on-vehicle lamp, and ordinary lighting. Especially, a white light source in which an LED and a phosphor are combined is drawing attention as a substitute for an incandescent light bulb, and LED light bulbs and so on having substantially the same shape as that of the incandescent light bulb are spreading in the market. Concrete products include, for example, an LED light bulb having an integrated lamp structure in which a globe is attached to a base portion on which a lamp cap is provided, an LED chip is disposed in the globe, and further a lighting circuit of the LED chip is provided in the base portion. At this time, the cap is electrically connected to the base portion.

Generally, when an incandescent light bulb is used, its brightness is adjusted by a user according to his/her preference. When the brightness is adjusted to a darker side, there is a tendency that emitted light becomes a reddish white light and its color temperature also decreases due to an emission characteristic of a tungsten filament. Such an emission characteristic of the incandescent light bulb is unconsciously accepted by people, and accordingly a new light emitting device, when proposed, is required to have the same emission characteristic as that of the incandescent light bulb.

Influences psychologically given by lighting include a Kruithof effect. A characteristic of a white light having a high color temperature is generally better as its illuminance is higher. For example, a bluish white light having a high color temperature gives a refreshing effect when having a high illuminance, but gives a gloomy and cold impression when having too low an illuminance.

On the other hand, a characteristic of a white light having a low color temperature is generally better as its illuminance is lower. For example, a reddish light such as a light of an incandescent lamp gives a calm atmosphere when having a low illuminance but gives a sultry and unpleasant impression when having a high illuminance.

Light control and toning characteristics in an incandescent light bulb stand to reason also in view of the aforesaid psychological influence. An LED light bulb or the like, when having a light control function, is required to have a color change characteristic similar to that of an incandescent light bulb. However, in a conventional light emitting device, though it is possible to freely adjust brightness of a white light at the same color temperature, it has been difficult to change the brightness according to a change of the color temperature of the white light.

In a case of a conventional white light source which gives a white light by the combination of an LED and a phosphor, it was possible to adjust brightness of the white light source by controlling a value of a current applied to the LED. However, even when brightness of the LED is adjusted, a color temperature of the white light does not change. Therefore, in order to change an emission color, there has been needs for changing the kind of the phosphor and the kind of the LED, and so on.

When a mixed phosphor is used as the phosphor, it is possible to change the emission color by changing a compounding ratio of phosphor materials, but in either case, it has been difficult to perform light control and toning at the same time.

In a case of a conventional LED light bulb which gives a white light by the combination of an LED emitting an ultraviolet or violet light and phosphors of the three primary colors, it is possible to freely change brightness by adjusting a current applied to the LED. However, it was not possible to change a color temperature of the white light. In order to obtain white lights having different color temperatures in such a type, it has been necessary to prepare a plurality of LED light bulbs of different kinds, with the kind of the phosphor or the compounding ratio of the phosphors of the three primary colors being varied.

In a conventional lighting control system capable of giving various emission colors by combining a main light source formed of a white light source which emits a light of a light bulb color and an auxiliary light source formed of a light source which emits red, blue, and green lights, it is possible to use the various emission lights according to various uses, but no consideration has been given to the adjustment of brightness according to a change of the emission color.

### RELEVANT REFERENCES

### Patent Reference

Reference 1: JP-B 4862098
Reference 2: JP-A 2007-299590

Further, in US 2012/056209 A1, a light emitting device includes a board; plural first light emitting elements and plural second light emitting elements; a first fluorescent layer; and a second fluorescent layer.

WO 2007/114614 A1 provides a light emitting device comprising a first light emitting portion and a second light emitting portion, which include light emitting diode chips and phosphors and are independently driven.

In US 2005/212404 A1 a white light LED assembly has at least two kinds of light-emitting units. The units can be a white light-emitting unit composed of red, green and blue LEDs, a white light-emitting unit composed of a blue and yellowish-green LEDs, a white light-emitting unit composed of a blue LED and yellow phosphor, or a white light-emitting units composed of UV LED and red, green and blue phosphors.

US 2012/326627 A1 describes systems and methods for controlling the emission of white light.

In US 2007/274093 A1 a LCD display comprises a backlight assembly that includes a backlight substrate, one or more first white LEDs coupled to the backlight substrate and configured to produce a first light output, and one or more second white LEDs coupled to the backlight substrate and configured to produce a second light output.

### SUMMARY

It is an object of one aspect of the present invention to provide a light emitting device which is capable of performing light control and toning at the same time and from which a natural white light can be obtained.
The object of the present invention is achieved by the subject-matter of the independent claims. Advantageous embodiments are defined in the dependent claims.

A light emitting device of an example includes at least a first light source which emits a first white light having a first color temperature and a second light source which emits a second white light having a second color temperature higher than the first color temperature, and emits a mixed white light of the first white light and the second white light. A color temperature of the mixed white light is lower as an emission intensity of the mixed white light is lower.

### BRIEF DESCRIPTION OF THE DRAWINGS

FIG. 1 is a cross-sectional view of a light emitting device.
FIG. 2A and 2B are charts illustrating relations between drive currents and emission characteristics of a light emitting device.
FIG. 3A and 3B are charts illustrating relations between drive currents and emission characteristics of a light emitting device.
FIG. 4 is a schematic view illustrating the arrangement of a plurality of light sources mounted on a substrate.
FIG. 5 is a cross-sectional view illustrating part of an LED light bulb.

### DETAILED DESCRIPTION

Hereinafter, a light emitting device of an embodiment will be concretely described with reference to the drawings.

### (First Embodiment)

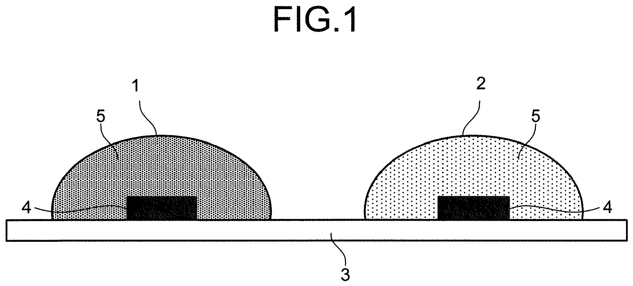

FIG. 1 is a cross-sectional view of a light emitting device of this embodiment. The light emitting device illustrated in FIG. 1 includes a white light source 1 and a white light source 2 which are mounted on a substrate 3.

As the substrate 3, a substrate of ceramic such as alumina or of plastic is used, for instance. On a front surface of the substrate 3 (further in its inner part as required), a wiring network (not illustrated) is provided. From a side surface or a bottom surface of the substrate 3, not-illustrated wiring lines are exposed, and the wiring lines are electrically connected to drive circuits such as lighting circuits (not illustrated) provided inside the light emitting device 1.

The white light source 1 and the white light source 2 each have an LED chip 4 and a phosphor film 5. The white light source 1 emits a first white light having a first color temperature. The white light source 2 emits a second white light having a second color temperature higher than the first color temperature. The light emitting device illustrated in FIG. 1 mixes the first white light and the second white light, thereby capable of emitting a mixed white light exhibiting an arbitrary intermediate color temperature whose upper limit and lower limit are the color temperatures of the first white light and the second white light.

To the LED chips 4, direct-current voltages are applied via the aforesaid lighting circuits. The LED chips 4 each turn on to radiate a light according to the applied direct-current voltages. As the LED chips 4, light emitting diodes are usable. The aforesaid light emitting diodes each emit a light having an emission peak wavelength in 370 nm to 420 nm. As each of the aforesaid light emitting diodes, a light emitting diode such as, for example, an InGaN-based one, a GaN-based one, or an AlGaN-based one which emits ultraviolet to violet lights is used. Electrodes of the LED chips 4 are electrically connected to the wiring network of the substrate 3.

The phosphor films 5 are formed so as to cover the LED chips 4. The aforesaid lights of the LED chips 4, after being absorbed by the phosphor films 5, are converted to visible lights longer in wavelength than the ultraviolet light or the violet light.

In FIG. 1, a cross section of each of the phosphor films 5 is a semi-spherical cross section, but the shape of the phosphor films 5 need not be limited to the semi-spherical shape. The phosphor films 5 may have any shape, but desirably, the phosphor films 5 are structured to cover peripheries of the LED chips 4 and prevent the lights from the LED chips 4 from leaking from gaps of the phosphor films 5.

In FIG. 1, one LED chip 4 is illustrated in each of the phosphor films 5, but the number of the chips need not be limited to one. However, when the LED chips 4 are used in plurality, the plural LED chips 4 are desirably covered by the single phosphor film 5.

The phosphor films 5 each contain an organic resin such as silicone and a phosphor dispersed in the organic resin. The phosphor emits a white light by being excited by the light of the light emitting diode. As the phosphor, a mixed phosphor which emits lights in at least the three primary colors such as red, green, and blue colors is used, for instance. Kinds and compounding ratios of phosphors used in the mixed phosphor may be any, but the kinds and the compounding ratios of the phosphors need to be set so that at least a white light from 1800 K to 2200 K and a white light from 2600 K to 3000 K, or a white light from 2500 K to 3000 K and a white light from 4800 K to 5800 are obtained.

In deciding the kinds and the compounding ratios of the used phosphors, it is important to take a general color rendering index Ra of the white light into consideration. In order to obtain a light close to a natural light, not only brightness and emission color of an illumination light itself but also how an object is seen is important. That is, a hue and so on of the illuminated object need to look similar to those when a natural light is used as lighting. For this purpose, the general color rendering index Ra of the mixed white light is desirably at least 90 or more at all intermediate color temperatures exhibited by the mixed white light of the first white light and the second white light.

It is desirable that a deviation between the color temperature of the mixed white light and a color temperature on a black body locus is within 0±0.002 K at all the intermediate color temperatures exhibited by the mixed white light of the first white light and the second white light. In order to realize such a white light, it is required to have lights with all the wavelengths in a visible light spectrum from about 400 nm to 700 nm and with a certain intensity or higher. For this purpose, it is necessary to consider not only a peak wavelength and brightness but also an emission spectrum shape and so on in emission characteristics of the phosphors used in the phosphor film 5, and all the phosphors cannot always be used. That is, in order to exhibit the effect of this embodiment, the selection of the kinds of the phosphors is important. In this embodiment, the following phosphors are desirably used.

As the phosphor used as a blue component of the white light (also called a blue phosphor), a phosphor whose emission peak wavelength is within a range of not less than 430 nm nor more than 460 nm is used, and, for example, a europium (Eu)-activated alkaline earth chlorophosphate phosphor having a composition expressed by a formula (1) is preferably used.
general formula:

(Sr_{1-x-y-z}BaₓCa_{y}Eu_{z})₅(PO₄)₃·Cl ... (1)

(In the formula, x, y, and z are numbers satisfying 0 ≤ x < 0.5, 0 ≤ y < 0.1, and 0.005 ≤ z < 0.1.)

As the phosphor used as a green component of the white light (also called a green phosphor), a phosphor whose emission peak wavelength is within a range of 490 nm to 580 nm is used, and for example, at least one selected from a group consisting of a europium (Eu)- and manganese (Mn)-activated alkaline earth aluminate phosphor having a composition expressed by a formula (2), a europium (Eu)- and manganese (Mn)-activated alkaline earth silicate phosphor having a composition expressed by a formula (3), a cerium (Ce)-activated rare-earth aluminate phosphor having a composition expressed by a formula (4), a europium (Eu)-activated sialon phosphor having a composition expressed by a formula (5), and a europium (Eu)-activated sialon phosphor having a composition expressed by a formula (6) is preferably used.
general formula:

(Ba_{1-x-y-z}SrₓCa_{y}Eu_{z})(Mg₁₋ᵤMnᵤ)Al₁₀O₁₇ ... (2)

(In the formula, x, y, z, and u are numbers satisfying 0 ≤ x < 0.2, 0 ≤ y < 0.1, 0.005 < z < 0.5, and 0.1 < u < 0.5.)
general formula:

(Sr_{1-x-y-z-u}BaₓMg_{y}Eu_{z}Mnᵤ)₂SiO₄... (3)

(In the formula, x, y, z, and u are numbers satisfying 0.1 ≤ x ≤ 0.35, 0.025 ≤ y ≤ 0.105, 0.025 ≤ z ≤ 0.25, and 0.0005 ≤ u ≤ 0.02.)
general formula:

RE₃AₓA_{15-x-y}B_{y}O₁₂:Ce_{z}... (4)

(In the formula, RE represents at least one element selected from a group consisting of Y, Lu, and Gd, A and B are elements making a pair, (A, B) is one of (Mg, Si), (B, Sc), and (B. In), and x, y, and z are numbers satisfying x < 2, y < 2, 0.9 ≤ x/y ≤ 1.1, and 0.05 ≤ z ≤ 0.5.)
general formula:

(Si, Al)₆(O, N)₈:Euₓ... (5)

(In the formula, x is a number satisfying 0 < x < 0.3.)
general formula:

(Sr₁₋ₓEuₓ)_{α}Si_{β}Al_{γ}O_{γ}N_{ω}... (6)

(In the formula, x, α, β, γ, δ, and ω are numbers satisfying 0 < x < 1, 0 < α ≤ 3, 12 ≤ β ≤ 14, 2 ≤ γ ≤ 3.5, 1 ≤ δ ≤ 3, and 20 ≤ ω ≤ 22.)

As the phosphor used as a red component of the white light (also called a red phosphor), a phosphor whose emission peak wavelength is within a range of 580 nm to 630 nm is used, and for example, at least one selected from a group consisting of a europium (Eu)-activated lanthanum oxysulfide phosphor having a composition expressed by a formula (7), a europium (Eu)- and bismuth (Bi)-activated yttrium oxide phosphor having a composition expressed by a formula (8), a europium-activated CASN phosphor having a composition expressed by a formula (9), and a europium (Eu)-activated sialon phosphor having a composition expressed by a formula (10) is preferably used.
general formula:

(La_{1-x-y}EuₓM_{y})₂O₂S... (7)

(In the formula, M represents at least one element selected from a group consisting of Sm, Ga, Sb, and Sn, x and y are numbers satisfying 0.08 ≤ x < 0.16 and 0.000001 ≤ y < 0.003.)
general formula:

(Y_{1-x-y}EuₓBi_{y})₂O₃... (8)

(In the formula, x and y are numbers satisfying 0.01 ≤ x < 0.15 and 0.001 ≤ y < 0.05.)
general formula:

(Ca_{1-x-y}SrₓEu_{y})SiAlN₃... (9)

(In the formula, x and y are numbers satisfying 0 ≤ x < 0.4 and 0 < y < 0.05)
general formula:

(Sr₁₋ₓEu_{z})_{α}Si_{β}Al_{γ}O_{δ}N_{ω}... (10)

(In the formula, x, α, β, γ, δ, and ω are numbers satisfying 0 < x < 1, 0 < α ≤ 3, 5 ≤ β ≤ 9, 1 ≤ γ ≤ 5, 0.5 ≤ δ ≤ 2, and 5 ≤ ω ≤ 15.)

Regarding the kinds of the usable phosphors, only the phosphors of the three primary colors of blue, green, and red are proposed, but the usable phosphors are not limited to the aforesaid phosphors of the three primary colors. For example, as a phosphor of an intermediate color of the phosphors of the three primary colors, a blue-green phosphor or a deep red phosphor is usable, for instance. Appropriately using the aforesaid phosphor of the intermediate color in addition to the phosphors of the three primary colors makes it possible to obtain even a white light whose general color rendering index Ra is over 95.

As the blue-green phosphor, a phosphor whose emission peak wavelength is within a range of 460 nm to 490 nm is usable, and for example, a europium (Eu)- and manganese (Mn)-activated alkaline earth silicate phosphor expressed by a formula (11) or the like is usable.
general formula:

(Ba_{1-x-y-z-u}SrₓMg_{y}Eu_{z}Mnᵤ)₂SiO₄... (11)

(In the formula, x, y, z, and u are numbers satisfying 0.1 ≤ x ≤ 0.35, 0.025 ≤ y ≤ 0.105, 0.025 ≤ z ≤ 0.25, and 0.0005 ≤ u ≤ 0.02.)

As the deep red phosphor, a phosphor whose emission peak wavelength is within a range of 630 nm to 780 nm is usable, and for example, a manganese (Mn)-activated magnesium phlorogermanate phosphor having a composition expressed by a formula (12), or the like is usable.
general formula:

αMgO·βMgF₂·(Ge₁₋ₓMnₓ)O₂ ... (12)

(In the formula, α, β, and x are numbers satisfying 3.0 ≤ α ≤ 4.0, 0.4 ≤ β ≤ 0.6, and 0.001 ≤ x ≤ 0.5.)

In the above composition formulas of the phosphors, the limitation of the composition ranges of the respective elements is to specify desired ranges for obtaining the effect of this embodiment. That is, when a ratio of each of the constituent elements in the above composition formulas is over the upper limit value or below the lower limit value of the aforesaid composition range, brightness of the phosphor or the emission color cannot exhibit a desirable characteristic, and the effect of this embodiment cannot be obtained.

By selecting the kinds of the phosphors constituting at least the three primary colors from the aforesaid phosphors which have appropriate emission spectrum characteristics and changing the compounding ratios, it is possible to obtain a plurality of kinds of white light sources different in color temperature. In the light emitting device of this embodiment, the white lights having at least two kinds of the color temperatures are used and the both are appropriately combined, whereby various mixed white lights whose brightness is controlled are obtained.

It is possible to change the brightness of the white lights by, for example, controlling the drive currents of the LED chips 4, by an ordinary phase control method used for the light control of a white LED light bulb, or the like. At this time, a control pattern of the currents or a pattern of the phase control can be arbitrarily changed, but in the light emitting device of this embodiment, the control is performed so that the white light having a higher color temperature becomes brighter.

For example, in the case of the current control, the following control is performed. After the color temperature of the mixed white light is set to the intermediate color temperature of those of the lights of the white light source 1 and the white light source 2, an emission intensity of the light of one of the white light source 1 and the white light source 2 is gradually increased, an emission intensity of the light of the other of the white light source 1 and the white light source 2 is gradually decreased, and current amounts supplied to the white light source 1 and the white light source 2 are adjusted so that a variation amount of the emission intensity of the light of the white light source 2 becomes larger than a variation amount of the emission intensity of the white light source 1, whereby the emission intensity of the mixed white light is controlled. The control of the current amounts can be performed by, for example, the lighting circuits.

### [First Example of Current Control]

As a light source having a low color temperature (white light source 1), a light source whose white light has a 2000 K color temperature is used, and as a light source having a high color temperature (white light source 2), a light source whose white light has a 2800 K color temperature is used. Currents on substantially the same level are passed to the two kinds of light sources respectively, whereby a mixed white light having a 2400 K color temperature is obtained as the light emitting device. At this time, values of the currents applied to the both light sources are not necessarily equal. This is because compounding ratios of mixed phosphors forming the respective light sources are different, and therefore, even when they are excited by energies with the same intensity, emitted lights having the same intensity cannot be obtained. Therefore, the currents applied to the respective light sources are finely adjusted so that a white having a color temperature between those of the both light sources are obtained. Pre-setting is made so that current values after this fine adjustment are fixed as initial values.

Subsequently, the current applied to the light source whose white light has the 2000 K color temperature is increased step by step from the initial value and at the same time, the value of the current applied to the light source whose white light has the 2800 K color temperature is decreased step by step from the initial value. At this time, the applied currents are adjusted so that a decrement of an emission intensity of the light source whose white light has the 2800 K color temperature becomes larger than an increment of an emission intensity of the light source whose white light has the 2000 K color temperature, and an emission intensity of the whole light emitting device is set to gradually decrease. Consequently, the mixed white light obtained in the whole light emitting device gradually decreases in the color temperature and also gradually decreases in the emission intensity. That is, the color temperature of the mixed white light becomes lower as the emission intensity of the mixed white light is lower. Then, when the value of the current applied to the light source whose white light has the 2800 K color temperature becomes zero, the color temperature of the mixed white light becomes 2000 K, which is the lowest value.

On the other hand, the mixed white light whose color temperature is higher than 2400 K can be obtained by the following procedure. The current applied to the light source whose white light has the 2000 K color temperature is decreased step by step from the initial value, and at the same time, the value of the current applied to the light source whose color temperature is 2800 K is increased step by step from the initial value. At this time, the applied currents are adjusted so that an increment of the emission intensity of the light of the light source whose white light has the 2800 K color temperature becomes larger than a decrement of the emission intensity of the light of the light source whose white light has the 2000 K color temperature, and the emission intensity of the light of the whole light emitting device is set so as to gradually increase. Consequently, the mixed white light obtained in the whole light emitting device gradually increases in the color temperature and gradually increases in the emission intensity. Then, when the value of the current applied to the light source whose white light has the 2000 K color temperature becomes zero, the color temperature of the mixed white light becomes 2800 K, which is the highest value.

### [Second Example of Current Control]

As a light source whose white light has a low color temperature (white light source 1), a light source whose white light has a 2800 K color temperature is used, and as a light source whose white light has a high color temperature (white light source 2), a light source whose white light has a 5300 K color temperature is used. Currents on substantially the same level are passed to the two kinds of light sources respectively, whereby a mixed white light whose color temperature is 4050 K is obtained as the light emitting device. At this time, values of the currents applied to the both light sources are not necessarily equal. This is because compounding ratios of mixed phosphors forming the respective light sources are different, and therefore, even when they are excited by energies with the same intensity, emitted lights having the same intensity cannot be obtained. Therefore, in order to obtain a white having a color temperature between those of the both light sources, the currents applied to the respective light sources are finely adjusted. Pre-setting is made so that current values after this fine adjustment are fixed as initial values.

Subsequently, the current applied to the light source whose white light has the 2800 K color temperature is increased step by step from the initial value and at the same time, the value of the current applied to the light source whose white light has the 5300 K color temperature is decreased step by step from the initial value. At this time, the applied currents are adjusted so that a decrement of an emission intensity of the light of the light source whose white light has the 5300 K color temperature becomes larger than an increment of an emission intensity of the light of the light source whose white light has the 2800 K color temperature, and an emission intensity of the light of the whole light emitting device is set to gradually decrease. Consequently, the mixed white light obtained in the whole light emitting device gradually decreases in the color temperature and also gradually decreases in the emission intensity. That is, the color temperature of the mixed white light becomes lower as the emission intensity of the mixed white light is lower. Then, when the value of the current applied to the light source whose white light has the 5300 K color temperature becomes zero, the color temperature of the mixed white light becomes 2800 K, which is the lowest value.

On the other hand, the mixed white light whose color temperature is higher than 4050 K can be obtained by the following procedure. The current applied to the light source whose white light has the 2800 K color temperature is decreased step by step from the initial value, and at the same time, the value of the current applied to the light source whose white light has the 5300 K color temperature is increased step by step from the initial value. At this time, the applied currents are adjusted so that an increment of the emission intensity of the light of the light source whose white light has the 5300 K color temperature becomes larger than a decrement of the emission intensity of the light of the light source whose white light has the 2800 K color temperature, and the emission intensity of the light of the whole light emitting device is set so as to gradually increase. Consequently, the mixed white light obtained in the whole light emitting device gradually increases in the color temperature and gradually increases in the emission intensity. Then, when the value of the current applied to the light source whose white light has the 2800 K color temperature becomes zero, the color temperature of the mixed white light becomes 5300 K, which is the highest value.

Regarding the current control pattern for adjusting the emission intensities of the lights of the respective light sources by using the above first current control example and second current control example, the adjustment is made in the above description so that the variation amount of the emission intensity of the light source with the higher color temperature becomes larger than the variation amount of the light source with the lower color temperature, but a pattern where the emission intensity of one of the light sources is fixed and that of the other light source is increased or decreased may be used.

In the above description, the methods of the pattern control are described in detail according to the procedures, but the above-described procedures do not necessarily have to be taken in an actual light emitting device. By taking the above-described procedures at a product design stage, it is possible to concretely find the values of the currents which are to be applied to the respective light sources at the respective color temperatures of the mixed white light. By storing these current values as data in advance and designing the device so that predetermined currents flow to the respective light sources when the color temperature is set to a desired color temperature, it is possible to obtain the light emitting device of this embodiment.

In the above procedures, the white light sources with the two kinds of color temperatures (the white light source 1 and the white light source 2) are used, but the number of the kinds need not be limited to two. Increasing the kinds of the light sources has a merit that white lights on the black body locus can be continuously and faithfully reproduced. However, when the number of the light sources is large, the method of the current control becomes complicated, and therefore, the number of the light sources is desirably decided in consideration of the both factors at the same time. In order to exhibit the effect of this embodiment, the combination of two kinds or three kinds of light sources is sufficient.

Further, in some case, the number of the white light sources is increased instead of the kind of the white light sources. At this time, as previously described, there is a method of covering the plural LED chips 4 by the single phosphor film 5, but a plurality of white light sources whose LED chips 4 are each independently covered by the phosphor film 5 may be used. When a light emitting device having brightness suitable for practical use is obtained, the number of the white light sources mounted on the substrate 3 is generally several tens, though depending on the size of the LED chips 4 and power used.

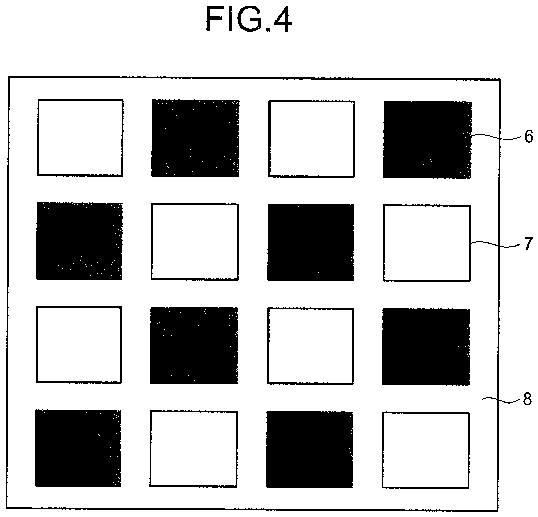

When the plural white light sources with the two kinds of color temperatures are used, they are preferably arranged as illustrated in FIG. 4, for instance. In the arrangement illustrated in FIG. 4, the color temperatures of the white light sources adjacent to each other are different, and in the mixed white light obtained in the whole light emitting device, a uniform white light can be obtained.

### EXAMPLES

### (Example 1A)

As white light sources used in a light emitting device, two kinds of white light sources (a white light source A and a white light source B) different in color temperature were prepared. On an upper surface of a center portion of an alumina planar substrate in a rectangular shape whose each side was10 mm, two LED chips with 400 µm were mounted at an about 3 mm interval and were connected to different power sources respectively. As the LED chips, InGaN-based diodes having a 405 emission peak wavelength and emitting violet to ultraviolet lights were used.

Meanwhile, as a blue phosphor, a europium (Eu)-activated alkaline earth chlorophosphate phosphor (Sr_{0.7}Ba_{0.2}Ca_{0.05}Eu_{0.05})₅(PO₄)₃·Cl in an amount of 10 mass% was prepared, as a green phosphor, a europium (Eu)- and manganese (Mn)-activated alkaline earth silicate phosphor (Sr_{0.599}Ba_{0.2}Mg_{0.1}Eu_{0.1}Mn_{0.001})₂SiO₄ in an amount of 20 mass% was prepared, as a red phosphor, a europium (Eu)-activated sialon phosphor (Sr_{0.5}Eu_{0.5})_{1.5}Si₇Al₃O_{1.5}N₁₀ in an amount of 70 mass% was prepared, and by fully mixing them, a mixed phosphor powder A was obtained. Further, three kinds of phosphors, which were the same as above but whose compounding ratios were changed, were mixed so that their mass% ratio became the blue phosphor: the green phosphor: the red phosphor = 20 : 30 : 50, whereby a mixed phosphor powder B was obtained.

Dimethyl silicone transparent resins each in an amount of 70 mass% were prepared to 30 mass% of each of these mixed phosphor powders, and the both were stirred and mixed, whereby two kinds of transparent resin slurries in which phosphor particles were dispersed were fabricated. Thereafter, the transparent resin slurries were applied on the two LED chips mounted on the substrate so as to separately surround the respective LED chips. Consequently, transparent resin films each containing the mixed phosphor A or the mixed phosphor B were formed around the respective LED chips. The shape of each of the transparent resin films was a substantially semi-spherical shape with an about 2 mm diameter and an about 0.5 mm thickness.

Table 1 presents measurement results of emission characteristics of thus obtained white light sources, out of which the white light source A is one in which the transparent resin containing the mixed phosphor powder A is applied and the white light source B is one in which the transparent resin containing the mixed phosphor powder B is applied. Note that the emission characteristics of the white light sources were measured by using Labsphere SLMS-1021. Here, 30 mA currents were passed separately to the both white light sources to light the white light sources, and the emission characteristics were measured.

**[Table 1]**

| WHITE LIGHT SOURCE | PHOSPHOR | COMPOUNDING RATIO (MASS%) | COLOR TEMPERATURE (K) | EFFICIENCY (lm/W) | Ra |
|---|---|---|---|---|---|
| A | BLUE | 10 | 2000 | 55 | 91 |
| | GREEN | 20 | | | |
| | RED | 70 | | | |
| B | BLUE | 20 | 2800 | 70 | 97 |
| | GREEN | 30 | | | |
| | RED | 50 | | | |

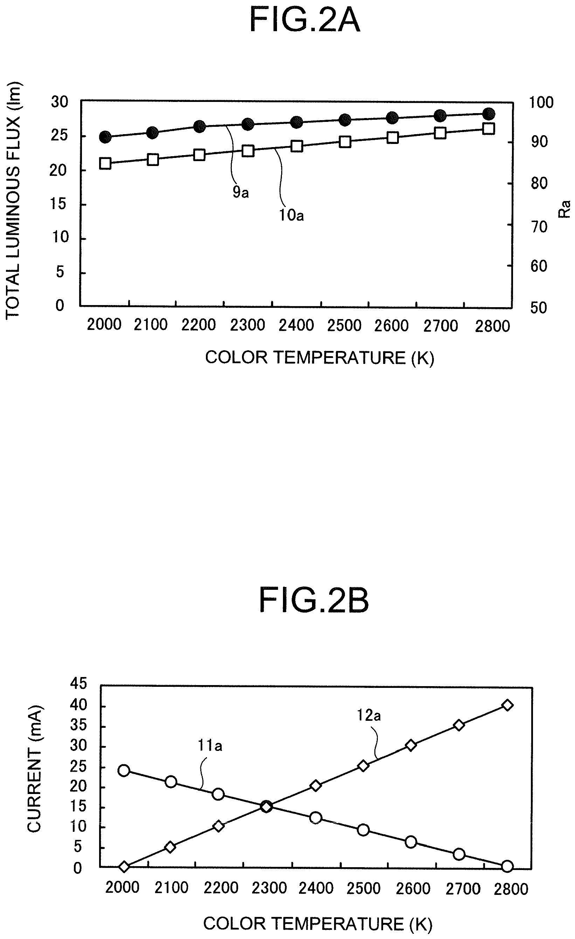

In the emission characteristics of the both white light sources, a color temperature of a white light of the white light source A was 2000 K, its efficiency was 55 lm/W, and its general color rendering index Ra was 91. On the other hand, a color temperature of a white light of the white light source B was 2800 K, its efficiency was 70 lm/W, and its general color rendering index Ra was 97. Since it could be confirmed that the emission characteristics of the respective white light sources satisfy the predetermined values, these two white light sources were connected to drive circuits respectively to fabricate a light emitting device. The light emitting device was lighted while currents passed to the respective white light sources were controlled to predetermined values, whereby mixed white lights with various color temperatures were obtained. FIG. 2A and FIG. 2B illustrate relations between changes of the values of the currents applied to the white light sources and the resultant color temperature and color rendering property of the mixed white light of the light emitting device.

FIG. 2A is a chart illustrating the emission characteristics of the mixed white light exhibited by the light emitting device and is a chart illustrating relations of a total luminous flux and the general color rendering index Ra of the mixed white light corresponding to each color temperature. FIG. 2B is a chart illustrating a relation between the values of the currents applied to the white light source A and the white light source B and the color temperature of the mixed white light exhibited by the light emitting device.

In FIG. 2A and FIG. 2B, the solid line 9a represents the relation between the color temperature and the general color rendering index Ra of the mixed white light, the solid line 10a represents the relation between the color temperature and the total luminous flux of the mixed white light, the solid line 11a represents the relation between the value of the current applied to the white light source A and the color temperature, and the solid line 12a represents the relation between the value of the current applied to the white light source B and the color temperature. As illustrated in FIG. 2A and FIG. 2B, when the current value to the white light source A was gradually decreased from 25 mA to 0 mA and at the same time the current value to the white light source B was gradually increased from 0 mA to 40 mA, the color temperature of the mixed white light in which the white lights from the both white light sources were mixed gradually increased from 2000 K to 2800 K. At this time, an emission intensity of the light emitting device increased in accordance with the increase of the color temperature. The general color rendering index Ra exhibited a substantially fixed value regardless of the change of the color temperature and changed within a range of 91 to 97. From this, it is seen that the light emitting device of this example can give a calm reddish white light to a vivid and fresh white light. Therefore, it can be said that the light emitting device has a toning function and a light control function capable of reproducing a characteristic close to that of a natural light.

### (Example 1B)

As white light sources used in a light emitting device, two kinds of white light sources (a white light source A and a white light source B) different in color temperature were prepared. On an upper surface of a center portion of an alumina planar substrate in a rectangular shape whose each side was 10 mm, two 400 µm LED chips were mounted at an about 3 mm interval and were connected to different power sources respectively. As the LED chips, InGaN-based diodes having a 405 emission peak wavelength and emitting violet to ultraviolet lights were used.

Meanwhile, as a blue phosphor, a europium (Eu)-activated alkaline earth chlorophosphate phosphor (Sr_{0.7}Ba_{0.2}Ca_{0.05}Eu_{0.05})₅(PO₄)₃·Cl in an amount of 25 mass% was prepared, as a green phosphor, a europium (Eu)- and manganese (Mn)-activated alkaline earth silicate phosphor (Sr_{0.599}Ba_{0.2}Mg_{0.1}Eu_{0.1}Mn_{0.001})₂SiO₄ in an amount of 30 mass% was prepared, as a red phosphor, a europium (Eu)-activated sialon phosphor (Sr_{0.5}Eu_{0.5})_{1.5}Si₇Al₃O_{1.5}N₁₀ in an amount of 45 mass% was prepared, and by fully mixing them, a mixed phosphor powder A was obtained. Further, three kinds of phosphors, which were the same as above but whose compounding ratios were changed, were mixed so that their mass% ratio became the blue phosphor : the green phosphor : the red phosphor = 45 : 30 : 25, whereby a mixed phosphor powder B was obtained.

Dimethyl silicone transparent resins each in an amount of 70 mass% were prepared to 30 mass% of each of these mixed phosphor powders, and the both were stirred and mixed, whereby two kinds of transparent resin slurries in which phosphor particles were dispersed were fabricated. Thereafter, the transparent resin slurries were applied on the two LED chips mounted on the substrate so as to separately surround the respective LED chips. Consequently, transparent resin films each containing the mixed phosphor A or the mixed phosphor B were formed around the respective LED chips. The shape of each of the transparent resin films was a substantially semi-spherical shape with an about 2 mm diameter and an about 0.5 mm thickness.

Table 2 presents measurement results of emission characteristics of thus obtained white light sources, out of which the white light source A is one in which the transparent resin containing the mixed phosphor powder A is applied and the white light source B is one in which the transparent resin containing the mixed phosphor powder B is applied. Note that the emission characteristics of the white light sources were measured by using Labsphere SLMS-1021. Here, 30 mA currents were passed separately to the both white light sources to light the white light sources, and the emission characteristics were measured.

**[Table 2]**

| WHITE LIGHT SOURCE | PHOSPHOR | COMPOUNDING RATIO (MASS%) | COLOR TEMPERATURE (K) | EFFICIENCY (lm/W) | Ra |
|---|---|---|---|---|---|
| A | BLUE | 25 | 2500 | 70 | 97 |
| | GREEN | 30 | | | |
| | RED | 45 | | | |
| B | BLUE | 45 | 5700 | 85 | 98 |
| | GREEN | 30 | | | |
| | RED | 25 | | | |

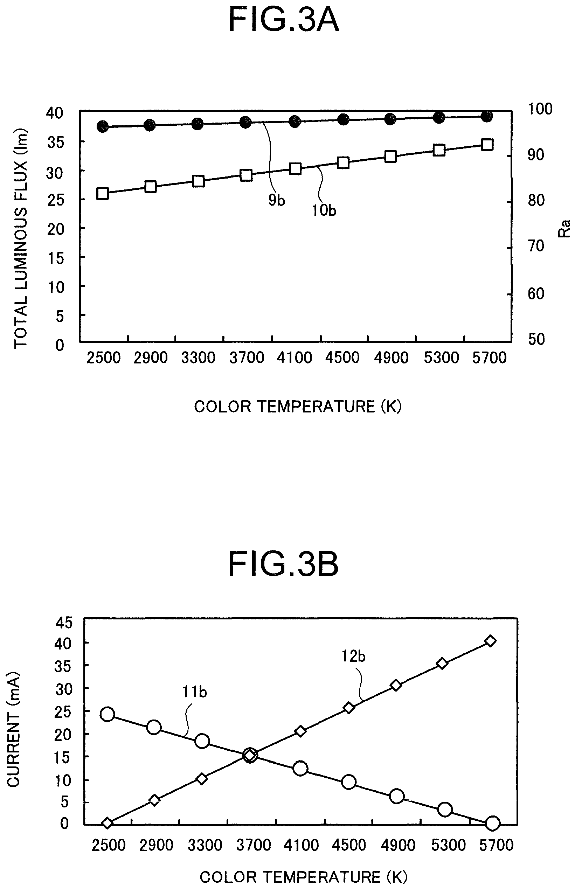

In the emission characteristics of the both white light sources, a color temperature of a white light of the white light source A was 2500 K, its efficiency was 70 lm/W, and its general color rendering index Ra was 97. On the other hand, a color temperature of a white light of the white light source B was 5700 K, its efficiency was 85 lm/W, and its general color rendering index Ra was 98. Since it could be confirmed that the emission characteristics of the respective white light sources satisfy the predetermined values, these two white light sources were connected to drive circuits respectively to fabricate a light emitting device. The light emitting device was lighted while currents passed to the respective white light sources were controlled to predetermined values, whereby white lights with various color temperatures were obtained. FIG. 3A and FIG. 3B illustrate relations between changes of values of the currents applied to the white light sources and the resultant color temperature and color rendering property of the light emitting device.

FIG. 3A is a chart illustrating the emission characteristics of the mixed white light exhibited by the light emitting device and is a chart illustrating relations of a total luminous flux and the general color rendering index Ra of the mixed white light corresponding to each color temperature. FIG. 3B is a chart illustrating a relation between the values of the currents applied to the white light source A and the white light source B and the color temperature of the mixed white light exhibited by the light emitting device. In FIG. 3A and FIG. 3B, the solid line 9b represents the relation between the color temperature and the general color rendering index Ra of the mixed white light, the solid line 10b represents the relation between the color temperature and the total luminous flux of the mixed white light, the solid line 11b represents the relation between the value of the current applied to the white light source A and the color temperature, and the solid line 12b represents the relation between the value of the current applied to the white light source B and the color temperature.

As illustrated in FIG. 3A and FIG. 3B, when the current value to the white light source A was gradually decreased from 24 mA to 0 mA and at the same time the current value to the white light source B was gradually increased from 0 mA to 40 mA, the color temperature of the mixed white light in which the white lights from the both white light sources were mixed gradually increased from 2500 K to 5700 K. At this time, an emission intensity of the light emitting device increased in accordance with the increase of the color temperature. The general color rendering index Ra exhibited a substantially fixed value regardless of the change of the color temperature and changed within a range of 97 to 98. From this, it is seen that the light emitting device of this example can give a calm reddish white light to a vivid and fresh white light. Therefore, it can be said that the light emitting device has a toning function and a light control function capable of reproducing a characteristic close to that of a natural light.

### (Example 2A to Example 5A)

Light emitting devices with the same structure as that of the example 1A were fabricated. However, in two kinds of white light sources for obtaining a mixed white light, the kind of used LED chips and the kind of phosphors were changed, and accordingly, white lights given by the respective white light sources exhibited different color temperatures from those of the example 1A, and a general color rendering index Ra was also different depending on each of the white light sources. Consequently, the white lights reproducible by the respective light emitting devices were also different in an upper limit value and a lower limit value of a color temperature and a general color rendering index Ra. However, the tendency that the emission intensity increases as the color temperature increases is the same as that in the example 1A. Table 3 presents the structures of the white light sources used in the respective light emitting devices and their light emitting characteristics.

**[Table 3]**

| | WHITE LIGHT SOURCE | LED (EMISSION PEAK WAVELENGTH) | PHOSPHOR | | | LIGHT EMITTING DEVICE | | |
|---|---|---|---|---|---|---|---|---|
| | | | EMISSION COLOR | CHEMICAL COMPOSITION | COMPOUNDING RATIO (mass%) | COLOR TEMPERATURE (K) | EFFICIENCY (lm/W) | Ra |
| EXAMPLE 2A | A | 385 | BLUE | (Sr_{0.7}Ba_{0.2}Ca_{0.05}Eu_{0.05})₅(PO₄)₃ · Cl | 5 | 1800 | 50 | 90 |
| | | | GREEN | (Sr_{0.445}Ba_{0.3}Mg_{0.05}Eu_{0.2}Mn_{0.005})₂SiO₄ | 20 | | | |
| | | | RED | (La_{0.899}Eu_{0.1}M_{0.001})₂O₂S | 75 | | | |
| | B | 385 | BLUE | (Sr_{0.7}Ba_{0.2}Ca_{0.05})₅(PO₄)₃ · Cl | 25 | 3000 | 75 | 98 |
| | | | GREEN | (Sr_{0.445}Ba_{0.3}Mg_{0.05}Eu_{0.2}Mn_{0.005})₂SiO₄ | 30 | | | |
| | | | RED | (La_{0.899}Eu_{0.1}M_{0.001})₂O₂S | 45 | | | |
| EXAMPLE 3A | A | 400 | BLUE | (Sr_{0.8}Ba_{0.1}Ca_{0.05}Eu_{0.05})₅(PO₄)₃ · Cl | 10 | 1900 | 53 | 91 |
| | | | GREEN | (Sr_{0.81}Ba_{0.1}Mg_{0.03}Eu_{0.05}Mn_{0.01})₂SiO₄ | 25 | | | |
| | | | RED | (Ca_{0.8}Sr_{0.1}Eu_{0.1})SiAlN₃ | 75 | | | |
| | B | 400 | BLUE | (Sr_{0.8}Ba_{0.1}Ca_{0.05}Eu_{0.05})₅(PO₄)₃ · Cl | 15 | 2600 | 68 | 96 |
| | | | GREEN | (Sr_{0.81}Ba_{0.1}Mg_{0.03}Eu_{0.01}Mn_{0.01})₂SiO₄ | 30 | | | |
| | | | RED | (Ca_{0.8}Sr_{0.1}Eu_{0.1})SiAlN₃ | 55 | | | |
| EXAMPLE 4A | A | 420 | BLUE | (Sr_{0.5}Ba_{0.4}Ca_{0.05}Eu_{0.05})₅(PO₄)₃ · Cl | 15 | 2200 | 57 | 93 |
| | | | GREEN | (Ba_{0.79}Sr_{0.1})Ca_{0.01})Eu_{0.1})(Mg_{0.55}Mn_{0.45})Al₁₀O₁₇ | 20 | | | |
| | | | RED | (Y_{0.88}Eu_{0.l}Bi_{0.02})₂O₃ | 65 | | | |
| | B | 420 | BLUE | (Sr_{0.5}Ba_{0.4}Ca_{0.05}Eu_{0.05})₅(PO₄)₃ · Cl | 20 | 2700 | 69 | 97 |
| | | | GREEN | (Ba_{0.79}Sr_{0.1}Ca_{0.01}Eu_{0.1})(Mg_{0.55}Mn_{0.45})Al₁₀O₁₇ | 30 | | | |
| | | | RED | (Y_{0.88}Eu_{0.1}Bi_{0.02})₂O₃ | 50 | | | |
| EXAMPLE 5A | A | 370 | BLUE | (Sr_{0.6}Ba_{0.3}Ca_{0.05}Eu_{0.05})₅(PO₄)₃ · Cl | 5 | 2100 | 55 | 92 |
| | | | BLUE-GREEN | (Ba_{0.549}Sr_{0.2}Mg_{0.1}Eu_{0.15}Mn_{0.001})₂SiO₄ | 5 | | | |
| | | | GREEN | Y₃Mg_{0.1}Al_{4.8}Si_{0.1}O₁₂:Ce_{0.2} | 20 | | | |
| | | | RED | (Sr_{0.92}Eu_{0.08})₂Si₆Al₂O₂N₁₂ | 55 | | | |
| | | | DEEP-RED | 3.5MgO · 0.5MgF₂ · (Ge_{0.5}Mn_{0.5})O₂ | 15 | | | |
| | B | 370 | BLUE | (Sr_{0.6}Ba_{0.3}Ca_{0.05}Eu_{0.05})₅(PO₄)₃ · Cl | 20 | 2800 | 69 | 98 |
| | | | BLUE-GREEN | (Ba_{0.649}Sr_{0.2}Mg_{0.1}Eu_{0.15}Mn_{0.001})₂SiO₄ | 5 | | | |
| | | | GREEN | Y₃Mg_{0.1}Al_{4.8}Si_{0.1}O₁₂:Ce_{0.2} | 20 | | | |
| | | | RED | (Sr_{0.92}Eu_{0.08})₂Si₆Al₂O₂N₁₂ | 40 | | | |
| | | | DEEP-RED | 3.5MgO · 0.5MgF₂ · (Ge_{0.5}Mn_{0.5})O₂ | 15 | | | |

### (Example 2B to Example 5B)

Light emitting devices with the same structure as that of the example 1B were fabricated. However, in two kinds of white light sources for obtaining a mixed white light, the kind of used LED chips and the kind of phosphors were changed, and accordingly, white lights given by the respective white light sources exhibited different color temperatures from those of the example 1B, and a general color rendering index Ra was also different depending on each of the white light sources. Consequently, the white lights reproducible by the light emitting devices were also different in an upper limit value and a lower limit value of a color temperature and a general color rendering index Ra. However, the tendency that the emission intensity increases as the color temperature increases is the same as that in the example 1B Table 4 presents the structures of the white light sources used in the respective light emitting devices and their light emitting characteristics.

**[Table 4]**

| | WHITE LIGHT SOURCE | LED (EMISSION PEAK WAVELENGTH) | PHOSPHOR | | | LIGHT EMITTING DEVICE | | |
|---|---|---|---|---|---|---|---|---|
| | | | EMISSION COLOR | CHEMICAL COMPOSITION | COMPOUNDING RATIO (mass%) | COLOR TEMPERATURE (K) | EFFICIENCY (lm/W) | Ra |
| EXAMPLE 2B | A | 385 | BLUE | (Sr_{0.7}Ba_{0.2}Ca_{0.05}Eu_{0.05})₅(PO₄)₃ · Cl | 25 | 3000 | 75 | 98 |
| | | | GREEN | (Sr_{0.445}Ba_{0.3}Mg_{0.05}Eu_{0.2}Mn_{0.005})₂SiO₄ | 30 | | | |
| | | | RED | (La_{0.899}Eu_{0.1}M_{0.001})₂O₂S | 45 | | | |
| | B | 385 | BLUE | (Sr_{0.7}Ba_{0.2}Ca_{0.05}Eu_{0.05})₅(PO₄)₃ · Cl | 50 | 5200 | 82 | 98 |
| | | | GREEN | (Sr_{0.445}Ba_{0.3}Mg_{0.05}Eu_{0.2}Mn_{0.005})₂SiO₄ | 30 | | | |
| | | | RED | (La_{0.899}Eu_{0.1}M_{0.001})₂O₂S | 20 | | | |
| EXAMPLE 3B | A | 400 | BLUE | (Sr_{0.8}Ba_{0.1}Ca_{0.05}Eu_{0.05})₅(PO₄)₃ · Cl | 15 | 2600 | 68 | 96 |
| | | | GREEN | (Sr_{0.81}Ba_{0.1}Mg_{0.03}Eu_{0.05}Mn_{0.01})₂SiO₄ | 30 | | | |
| | | | RED | (Ca_{0.8}Sr_{0.1}Eu_{0.1})SiAlN₃ | 55 | | | |
| | B | 400 | BLUE | (Sr_{0.8}Ba_{0.1}Ca_{0.05}Eu_{0.05})₅(PO₄)₃ · Cl | 45 | 5000 | 80 | 97 |
| | | | GREEN | (Sr_{0.81}Ba_{0.1}Mg_{0.03}Eu_{0.05}Mn_{0.01})₂SiO₄ | 35 | | | |
| | | | RED | (Ca_{0.8}Sr_{0.1}Eu_{0.1})SiAlN₃ | 20 | | | |
| EXAMPLE 4B | A | 420 | BLUE | (Sr_{0.5}Ba_{0.4}Ca_{0.05}Eu_{0.05})₅(PO₄)₃ · Cl | 20 | 2700 | 69 | 97 |
| | | | GREEN | (Ba_{0.79}Sr_{0.1}Ca_{0.01}Eu_{0.1})(Mg_{0.55}Mn_{0.45})Al₁₀O₁₇ | 30 | | | |
| | | | RED | (Y_{0.88}Eu_{0.1}Bi_{0.02})₂O₃ | 50 | | | |
| | B | 420 | BLUE | (Sr_{0.5}Ba_{0.4}Ca_{0.05}Eu_{0.05})₅(PO₄)₃ · Cl | 45 | 5500 | 84 | 97 |
| | | | GREEN | (Ba_{0.79}Sr_{0.1}Ca_{0.01}Eu_{0.1})(Mg_{0.55}Mn_{0.45})Al₁₀O₁₇ | 30 | | | |
| | | | RED | (Y_{0.88}Eu_{0.1}Bi_{0.02})₂O₃ | 25 | | | |
| EXAMPLE 5B | A | 370 | BLUE | (Sr_{0.6}Ba_{0.3}Ca_{0.05}Eu_{0.05})₅(PO₄)₃ · Cl | 20 | 2800 | 69 | 98 |
| | | | BLUE-GREEN | (Ba_{0.549}Sr_{0.2}Mg_{0.1}Eu_{0.15}Mn_{0.001})₂SiO₄ | 5 | | | |
| | | | GREEN | Y₃Mg_{0.1}Al_{4.8}Si_{0.1}O₁₂:Ce_{0.2} | 20 | | | |
| | | | RED | (Sr_{0.92}Eu_{0.08})₂Si₆Al₂O₂N₁₂ | 40 | | | |
| | | | DEEP-RED | 3.5MgO · 0.5MgF₂ · (Ge_{0.5}Mn_{0.5})O₂ | 15 | | | |
| | B | 370 | BLUE | (Sr_{0.6}Ba_{0.3}Ca_{0.05}Eu_{0.05})₅(PO₄)₃ · Cl | 35 | 4900 | 79 | 98 |
| | | | BLUE-GREEN | (Ba_{0.549}Sr_{0.2}Mg_{0.1}Eu_{0.15}Mn_{0.001})₂SiO₄ | 5 | | | |
| | | | GREEN | Y₃Mg_{0.1}Al_{4.8}Si_{0.1}O₁₂:Ce_{0.2} | 15 | | | |
| | | | RED | (Sr_{0.92}Eu_{0.08})₂Si₆Al₂O₂N₁₂ | 40 | | | |
| | | | DEEP-RED | 3.5MgO · 0.5MgF₂ · (Ge_{0.5}Mn_{0.5})O₂ | 5 | | | |

### (Example 6)

White light sources 31 (a white light source A and a white light source B) which are the same as those used in the example 1A and the example 1B were used to fabricate an LED light bulb 30. The combination of LED chips and phosphors is the same as that in the example 1A and the example 1B.

40 pieces of the white light sources A and 40 pieces of the white light sources B were prepared, and totally 80 pieces of the white light sources 31 were mounted on a substrate. As illustrated in FIG. 4, the white light sources A6 and the white light sources B7 are arranged alternately on the substrate 8 so that the white light sources of the same kind are not adjacent to each other and are arranged so that a rectangular shape is formed as a whole. Note that, in FIG. 4, the arrangement of the white light sources is schematically explained and the number of the white light sources is reduced and wiring lines are omitted.

Out of the white light sources 31 arranged in the rectangular shape, 40 pieces of the white light sources of the same kind were serially connected and were connected to different lighting circuits respectively.

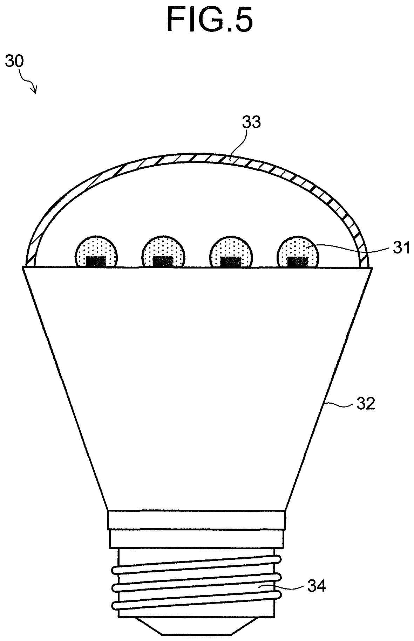

The substrate 8 on which the white light sources are mounted is placed on a base 32 having an E26 cap 34, and an upper portion of the base is covered by a globe 33 made of resin, whereby the LED light bulb 30 illustrated in FIG. 5 is completed.

The globe 33 is made of resin and is made of polycarbonate resin in which white fine particles are dispersed. The globe 33 has a dome shape, a thickness of the globe 33 is about 1 mm, a diameter of its largest portion is 63 mm, and a diameter of its attachment portion to the base 32 is 59 mm. The globe 33 is structured to be fixable to the base 32 by fitting.

The completed LED light bulb was lighted, and characteristics of an emitted white light, such as a color temperature, brightness, and a general color rendering index Ra were measured. The obtained emission characteristics were similar to the emission characteristics of the example 1A and the example 1B, and thus it exhibited brightness high enough to be practically used and exhibited an excellent color rendering property. Further, the LED light bulb of this example could be light-controlled and toned at the same time, and a relation between its brightness and emission color was similar to that of an incandescent light bulb.

## Claims

1. A light emitting device comprising:
a first white light source to emit a first white light having a first color temperature of 2500 K to 3000 K;
a second white light source to emit a second white light having a second color temperature of 4800 K to 5800 K; and
a lighting circuit to adjust current amounts supplied to the first and second white light sources so that a color temperature of a mixed white light of the first and second white lights is lowered accordingly as an emission intensity of the mixed white light is lowered, the lighting circuit being configured to set the color temperature of the mixed white light to an intermediate color temperature between the first and second color temperatures, and then increase an emission intensity of one of the first and second white lights and decrease an emission intensity of the other of the first and second white lights so that an emission intensity variation amount of the second white light exceeds an emission intensity variation amount of the first white light,
the first and second white light sources each including:
a light emitting diode to emit light having an emission peak wavelength in 370 nm to 420 nm; and
a mixed phosphor to convert the light from the diode to the first white light or the second white light, the mixed phosphor containing a red phosphor, a green phosphor, and a blue phosphor,
wherein, at all intermediate color temperatures exhibited by the mixed white light, a general color rendering index Ra of the mixed white light is 90 or more.

2. The device according to claim 1,
wherein, at all intermediate color temperatures exhibited by the mixed white light, a deviation between the color temperature of the mixed white light and a color temperature on a black body locus is 0+0.002.

3. The device according to claim 1,
wherein the blue phosphor is at least one selected from the group consisting of a europium (Eu) -activated alkaline earth chlorophosphate phosphor and a europium (Eu)-activated alkaline earth aluminate phosphor.

4. The device according to claim 1,
wherein the green phosphor is at least one selected from the group consisting of a europium (Eu)- and manganese (Mn)-activated alkaline earth aluminate phosphor, a europium (Eu)- and manganese (Mn)-activated alkaline earth silicate phosphor, a cerium (Ce)-activated rare-earth aluminate phosphor, and a europium (Eu)-activated sialon phosphor.

5. The device according to claim 1,
wherein the red phosphor is at least one selected from the group consisting of a europium (Eu) -activated lanthanum oxysulfide phosphor, a europium (Eu)- and bismuth-activated yttrium oxide phosphor, a europium (Eu)-activated CASN phosphor, and a europium (Eu)-activated sialon phosphor, wherein the europium (Eu) -activated CASN phosphor is expressed by the formula: (Ca_{1-x-y}SrₓEu_{y}) SiAlN₃, where x and y are numbers satisfying 0 ≤ x < 0.4 and 0 < y < 0.05.

6. The device according to claim 1,
wherein the first white light source and the second white light source each have a phosphor film provided to cover a periphery of the light emitting diode and containing the mixed phosphor.

7. The device according to claim 1,
wherein a plurality of the first white light sources and a plurality of the second white light sources are arranged on a substrate; and the white light sources arranged at adjacent positions emit white lights different in color temperature from each other.

8. An LED light bulb comprising:
a base portion on which the light emitting device according to claim 1 is installed;
a globe attached to the base portion so as to cover the light emitting device; and
a cap electrically connected to the base portion.

## Patentansprüche

1. Lichtemittierende Vorrichtung, umfassend:
eine erste Weißlichtquelle zum Emittieren eines ersten Weißlichts mit einer ersten Farbtemperatur von 2500 K bis 3000 K;
eine zweite Weißlichtquelle zum Emittieren eines zweiten Weißlichts mit einer zweiten Farbtemperatur von 4800 K bis 5800 K; und
einen Beleuchtungsstromkreis zum Anpassen von in die erste und die zweite Weißlichtquelle eingespeisten Strommengen, sodass eine Farbtemperatur eines aus dem ersten und dem zweiten Weißlicht gemischten Weißlichts dementsprechend herabgesetzt wird wie eine Emissionsintensität des gemischten Weißlichts herabgesetzt wird, wobei der Beleuchtungsstromkreis dazu konfiguriert ist, die Farbtemperatur des gemischten Weißlichts auf eine Zwischenfarbtemperatur zwischen der ersten und der zweiten Farbtemperatur einzustellen und dann eine Emissionsintensität eines des ersten und des zweiten Weißlichts zu erhöhen und eine Emissionsintensität des anderen des ersten und des zweiten Weißlichts zu verringern, sodass eine Emissionsintensitätsschwankungsmenge des zweiten Weißlichts eine Emissionsintensitätsschwankungsmenge des ersten Weißlichts übersteigt,
wobei die erste und die zweite Weißlichtquelle jeweils einschließen:
eine Leuchtdiode zum Emittieren eines Lichts, das eine Emissionsspitzenwellenlänge bei 370 nm bis 420 nm aufweist; und
einen Mischphosphor zum Umwandeln des Lichts aus der Diode in das erste Weißlicht oder das zweite Weißlicht, wobei der Mischphosphor einen roten Phosphor, einen grünen Phosphor und einen blauen Phosphor enthält,
wobei bei allen von dem gemischten Weißlicht gezeigten Zwischenfarbtemperaturen ein allgemeiner Farbwiedergabe-Index Ra des gemischten Weißlichts 90 oder mehr beträgt.

2. Vorrichtung nach Anspruch 1,
wobei bei allen von dem gemischten Weißlicht gezeigten Zwischenfarbtemperaturen eine Abweichung zwischen der Farbtemperatur des gemischten Weißlichts und einer Farbtemperatur auf einem Schwarzkörperort 0±0,002 beträgt.

3. Vorrichtung nach Anspruch 1,
wobei der blaue Phosphor zumindest einer ist, der aus der Gruppe ausgewählt ist, die aus einem mit Europium (Eu) aktivierten Erdalkali-Chlorphosphat-Phosphor und einem mit Europium (Eu) aktivierten Erdalkali-Aluminat-Phosphor besteht.

4. Vorrichtung nach Anspruch 1,
wobei der grüne Phosphor zumindest einer ist, der aus der Gruppe ausgewählt ist, die aus einem mit Europium (Eu) und Mangan (Mn) aktivierten Erdalkali-Aluminat-Phosphor, einem mit Europium (Eu) und Mangan (Mn) aktivierten Erdalkali-Silikat-Phosphor, einem mit Cer (Ce) aktivierten Seltene-Erden-Aluminat-Phosphor und einem mit Europium (Eu) aktivierten Sialon-Phosphor besteht.

5. Vorrichtung nach Anspruch 1,
wobei der rote Phosphor zumindest einer ist, der aus der Gruppe ausgewählt ist, die aus einem mit Europium (Eu) aktivierten Lanthan-Oxisulfid-Phosphor, einem mit Europium (Eu) und Wismut aktivierten Yttriumoxid-Phosphor, einem mit Europium (Eu) aktivierten CASN-Phosphor und einem mit Europium (Eu) aktivierten Sialon-Phosphor besteht, wobei der mit Europium (Eu) aktivierte CASN-Phosphor durch die folgende Formel ausgedrückt wird: (Ca_{1-x-y}SrₓEu_{y}) SiAlN₃, wobei x und y Zahlen sind, die 0 ≤ x < 0,4 und 0 ≤ y < 0,05 erfüllen.

6. Vorrichtung nach Anspruch 1,
wobei die erste Weißlichtquelle und die zweite Weißlichtquelle je eine Phosphorschicht aufweisen, die bereitgestellt ist, um einen Umfang der Leuchtdiode abzudecken, und die den Mischphosphor enthält.

7. Vorrichtung nach Anspruch 1,
wobei eine Vielzahl der ersten Weißlichtquellen und eine Vielzahl der zweiten Weißlichtquellen auf einem Substrat angeordnet sind;
und die an benachbarten Positionen angeordneten Weißlichtquellen Weißlicht emittieren, das sich in der Farbtemperatur voneinander unterscheidet.

8. LED-Glühbirne, umfassend:
einen Basisabschnitt, auf dem die lichtemittierende Vorrichtung nach Anspruch 1 installiert ist;
eine Leuchtenglocke, die an dem Basisabschnitt befestigt ist, um die lichtemittierende Vorrichtung abzudecken; und
eine Kappe, die elektrisch mit dem Basisabschnitt verbunden ist.

## Revendications

1. Dispositif électroluminescent comprenant :
une première source de lumière blanche pour émettre une première lumière blanche ayant une première température de couleur de 2 500 K à 3 000 K ;
une seconde source de lumière blanche pour émettre une seconde lumière blanche ayant une seconde température de couleur de 4 800 K à 5 800 K ; et
un circuit d'éclairage pour ajuster des quantités de courant fournies aux première et seconde sources de lumière blanche de sorte qu'une température de couleur d'une lumière blanche mixte des première et seconde lumières blanches est abaissée à mesure qu'une intensité d'émission de la lumière blanche mixte est abaissée, le circuit d'éclairage étant configuré pour régler la température de couleur de la lumière blanche mixte à une température de couleur intermédiaire entre les première et seconde températures de couleur, et ensuite augmenter une intensité d'émission de l'une des première et seconde lumières blanches et diminuer une intensité d'émission de l'autre des première et seconde lumières blanches de sorte qu'une quantité de variation d'intensité d'émission de la seconde lumière blanche dépasse une quantité de variation d'intensité d'émission de la première lumière blanche,
les première et seconde sources de lumière blanche incluant chacune :
une diode électroluminescente pour émettre une lumière ayant une longueur d'onde de pic d'émission de 370 nm à 420 nm ; et
un luminophore mixte pour convertir la lumière provenant de la diode en la première lumière blanche ou la seconde lumière blanche, le luminophore mixte contenant un luminophore rouge, un luminophore vert et un luminophore bleu,
dans lequel, à toutes les températures de couleur intermédiaires présentées par la lumière blanche mixte, un indice de rendu de couleur général Ra de la lumière blanche mixte est de 90 ou plus.

2. Dispositif selon la revendication 1,
dans lequel, à toutes les températures de couleur intermédiaires présentées par la lumière blanche mixte, un écart entre la température de couleur de la lumière blanche mixte et une température de couleur sur un locus de corps noir est de 0 ± 0,002.

3. Dispositif selon la revendication 1,
dans lequel le luminophore bleu est au moins un choisi dans le groupe constitué d'un luminophore de chlorophosphate alcalino-terreux activé par l'europium (Eu) et d'un luminophore d'aluminate alcalino-terreux activé par l'europium (Eu).

4. Dispositif selon la revendication 1,
dans lequel le luminophore vert est au moins un choisi dans le groupe constitué d'un luminophore d'aluminate alcalino-terreux activé par l'europium (Eu) et le manganèse (Mn), d'un luminophore de silicate alcalino-terreux activé par l'europium (Eu) et le manganèse (Mn), d'un luminophore d'aluminate de terres rares activé par le cérium (Ce), et d'un luminophore de sialon activé par l'europium (Eu).

5. Dispositif selon la revendication 1,
dans lequel le luminophore rouge est au moins un choisi dans le groupe constitué d'un luminophore d'oxysulfure de lanthane activé par l'europium (Eu), d'un luminophore d'oxyde d'yttrium activé par l'europium (Eu) et le bismuth, d'un luminophore de CASN activé par l'europium (Eu), et d'un luminophore de sialon activé par l'europium (Eu), dans lequel le luminophore de CASN activé par l'europium (Eu) est exprimé par la formule : (Ca_{1-x-y}SrₓEu_{y})SiAlN₃, où x et y sont des nombres satisfaisant 0 ≤ x < 0,4 et 0 < y < 0,05.

6. Dispositif selon la revendication 1,
dans lequel la première source de lumière blanche et la seconde source de lumière blanche ont chacune un film de luminophore prévu pour couvrir une périphérie de la diode électroluminescente et contenant le luminophore mixte.

7. Dispositif selon la revendication 1,
dans lequel une pluralité des premières sources de lumière blanche et une pluralité des secondes sources de lumière blanche sont agencées sur un substrat ; et les sources de lumière blanche agencées au niveau de positions adjacentes émettent des lumières blanches différentes en termes de température de couleur les unes des autres.

8. Ampoule lumineuse à DEL comprenant :
Une partie de base sur laquelle le dispositif électroluminescent selon la revendication 1 est installé ;
un globe attaché à la partie de base de façon à couvrir le dispositif électroluminescent ; et
une coiffe électriquement connectée à la partie de base.
